Europäisches Patentamt

European Patent Office

Office européen des brevets

(19)

(11) Publication number: **0 024 874**

**A1**

(12) # EUROPEAN PATENT APPLICATION

(21) Application number: **80302866.1**

(22) Date of filing: **19.08.80**

(51) Int. Cl.³: **G 11 C 8/00**
**G 11 C 11/24**

(30) Priority: **24.08.79 JP 108364/79**

(43) Date of publication of application:
**11.03.81 Bulletin 81/10**

(84) Designated Contracting States:
**DE FR GB**

(71) Applicant: **MITSUBISHI DENKI KABUSHIKI KAISHA**
**2-3, Marunouchi 2-chome Chiyoda-ku**
**Tokyo100(JP)**

(72) Inventor: **Matsui, Hideo**
**Room No.7-104 Chateau Shin-Osaka, 4-18**
**Miyahara 5-chome Yodogawa-ku Osaka(JP)**

(74) Representative: **Messulam, Alec Moses et al,**
**MARKS & CLERK 57/60 Lincoln's Inn Fields**
**London WC2A 3LS(GB)**

(54) **Memory control circuit with a plurality of address and bit groups.**

(57) This invention relates to a memory control circuit having a plurality of address groups and a plurality of bit groups running in rows and columns to form a matrix, and a plurality of memory cells (30', 32' . . .40') disposed at the intersection of the matrix.

With a view to providing such a circuit in which two or more memory cells may be selected simutaneously for writing and reading purposes, each cell is connected to a plurality of address lines (10a, 10'a) and a plurality of bit lines (20c, 20'c). A first peripheral control unit (50) selects the first address and bit lines in response to a first control signal and a second peripheral control unit (50') selects the second address and bit lines in response to a second control signal.

FIG.2.

Croydon Printing Company Ltd.

TITLE MODIFIED
see front page

- 1 -

Memory Control Circuit.

This invention relates to a memory control circuit comprising a plurality of address groups and a plurality of bit groups running in rows and columns to form a matrix, and a plurality of memory cells disposed at the intersections of the matrix.

The conventional type of memory circuits forming the background of the present invention has comprised a plurality of memory cells disposed in rows and columns, a single address line connected to those memory cells arranged in each row and a single bit line connected to those memory cells arranged in each column. Then a peripheral control unit is connected to all the address and bit lines and responsive to control signals applied thereto to select one of the address lines and one of the bit lines as determined by the control signals and therefore that memory cell connected to the selected address and bit lines. Then data are applied via the selected bit line to the selected memory cell in which the data are stored, as an electric charge, on a data storing capacitor involved. Also that memory cell from which data are to be read out is selected in the same manner as in the writing operation as described above by control signals and data stored on the associated capacitor is read out on a selected one of the bit lines.

It is desirable to write and read simultaneously data in and out from not less than two memory cells disposed in such a memory circuit as described above in order to expand the field to which memory circuits are applied. Accordingly it is an object of the present invention to provide a new and improved memory control circuit for selecting simultaneously not less than two of memory cells disposed in rows and columns for writing and reading purposes.

The present invention provides a memory control circuit comprising a plurality of address groups and a plurality of bit groups running in rows and columns to form a matrix, and a plurality of memory cells (30', 32') disposed at the intersection of the matrix, characterised in that each of the address groups includes a plurality of address lines (10a, 10'a) disposed in parallel to one another, and that each of the bit groups includes a plurality of bit lines (20a, 20'a) disposed in parallel to one another, the number of address lines and the number of bit lines being equal, and that the memory cells (30', 32'..) arranged in each row are connected to said plurality of address lines included in a matching one of the address group, the memory cells arranged in each column being connected to said plurality of bit lines included in a matching one of the bit groups.

A preferred embodiment of the present invention comprises a memory control circuit comprising a plurality of address groups and a plurality of bit groups running in rows and columns to form a matrix, and a plurality
of memory cells (30', 32'  ) disposed at the intersection
of the matrix characterised in that each of the address
groups includes first and second address lines (10a, 10'a)
disposed in parallel to each other, and that each of said
bit groups includes first and second bit lines disposed in
parallel to each other, and that the memory cells (30',32')
arranged in each row are connected to said first and second
address lines included in a matching one of the address
groups, said memory cells arranged in each column being
connected to said first and second bit lines included in
a matching one of the bit groups.

A further feature of the preferred embodiment of the
invention is that each of the memory cells includes a
first MOS field effect transistor having one main electrode
connected to an associated one of the first address lines,
a second MOS field effect transistor having one main
electrode connected to an associated one of the second
bit lines, the other main electrode, and a gate electrode
connected to an associated one of the second address lines,
and a capacitor connected at one end to the other main
electrodes of the first and second field effect transistors.

The present invention will now be described further,
by way of example, with reference to the accompanying
drawings, in which:

Figure 1 is a schematic block diagram of a conventional memory circuit useful in explaining the background of the present invention; and

Figure 2 is a schematic block diagram of a memory circuit embodying the present invention.

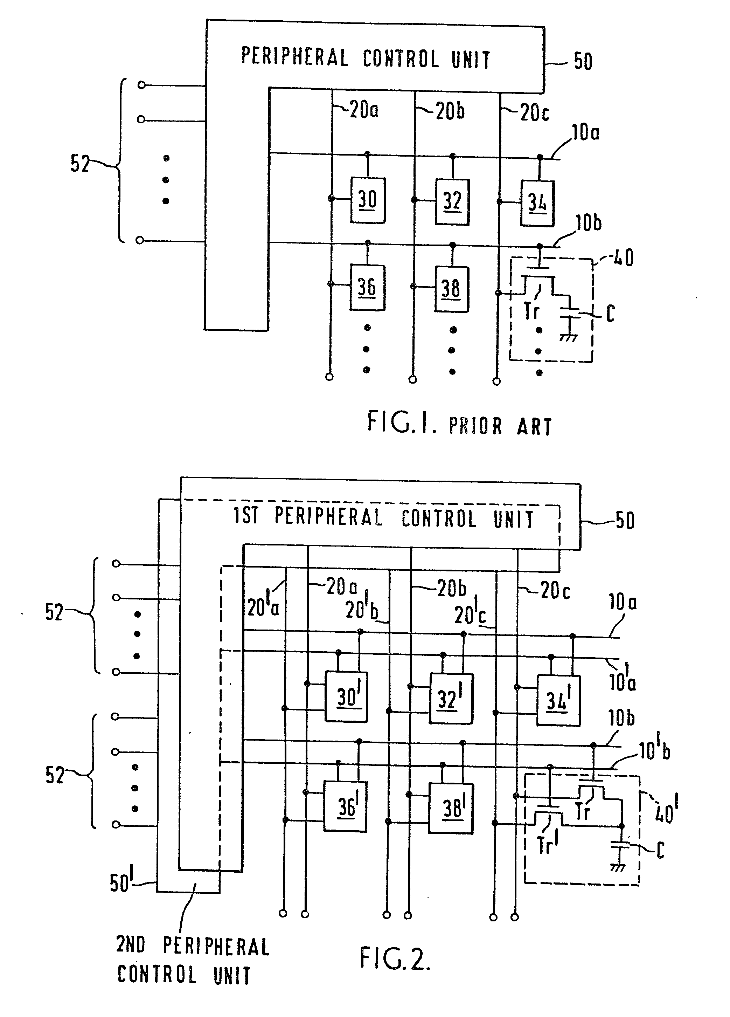

In figure 1, there is illustrated a conventional memory device. The arrangement illustrated comprises a plurality of address lines 10a, 10b, ...., running in rows and a plurality of bit lines 20a, 20b, 20c,....., running in a column to form a matrix. Then a plurality of memory cells 30, 32, 34, 36, 40,......, are disposed at intersections in the matrix and connected to the associated address and bit lines respectively.

In the example illustrated the memory cells 30, 32 and 34 are disposed in the first row of the matrix and connected to the address line 10 and the memory cells 36, 38 and 40 are disposed in the second row of the matrix and connected to the address line 10b. Also the memory cells 30 and 36 are disposed in the first column of the matrix and connected to the bit line 20a and the memory cells 32 and 38 are disposed in the second column thereof and connected to the bit line 20b. Similarly the memory cells 34 and 40 are disposed in the third column of the matrix and connected to the bit line 20c.

All the memory cells are identical in contruction to one another. Each of the memory cells includes an MOS field effect transistor Tr having a gate electrode connected to the associated address line 10a or 10b, one main electrode in this case a drain electrode connected to the associated bit line 20a, 20b or 20c and the other main electrode or a source electrode connected to a capacitor C subsequently connected to ground as shown in block 40 in Figure 1.

All the address lines 10a, 10b, ....., and the bit lines 20a, 20b, 20c are connected at one end to a peripheral control unit 50 subsequently connected to a plurality of control lines 52.

In operation, the peripheral control unit 50 responds to a control signal such as an address applied thereto through the control lines 52 to select that address line, as determined by the address signal, for example, the address line 10b to put it at a predetermined potential. Simultaneously the peripheral control unit 50 is applied with another control signal to select that bit line as determined by the latter control signal, for example, the bit line 20c resulting in the selection of that memory cell connected to the selected address and bit lines, in this case the memory cell 40.

At that time, the MOS field effect transistor Tr included in the selected memory cell 40 is turned on, and data is supplied via the selected bit line 20c to the now conducting transistor Tr. Therefore, the data is stored on the capacitor C.

Upon reading out the data stored on the capacitor C, control signals are similarly applied to the peripheral control unit 50 to elect the address and bit lines and therefore one of the memory cells, for example, the cell 40. Then the data stored on the capacitor C is read out on the bit line 20c through the transistor Tr now in its conducting state.

Conventional memory devices such as shown in Figure 1 have included only the single set of the address lines and the single set of the bit lines and therefore have not been able to select simultaneously more than one of the memory cells for writing and reading purposes. It is desirable to permit memory devices to select simultaneously at least two memory cells to write and read out data in and from the selected memory cells in order to extend the field to which the memory circuits are applicable.

The present invention provides a memory control circuit enabled to select simultaneously not less than two memory cells involved by providing at least two selection circuits for selecting the memory cells.

Referring now to Figure 2 wherein like reference numerals and characters designate the components identical to those shown in Figure 1, there is illustrated an embodiment of the memory control circuit of the present invention. The arrangement illustrated is different from that shown in Figure 1 principally in that in Figure 2 each of the address lines shown in Figure 1 is replaced by an address group including a pair of address lines and each of the bit lines shown in Figure 1 is replaced by a bit group including a pair of bit lines.

More specifically, a pair of first and second address lines 10a and 10'a are connected to the memory cells 30', 32', 34' disposed in the first row of the matrix to form a first address group and another pair of first and second address lines 10b and 10'b are connected to the memory cells 36', 38' and 408 disposed in the second row thereof to form a second address group and so on. Similarly a pair of first and second bit lines 20a and 20'a are connected to the memory cells 30' and 36' disposed in the first column of the memory circuit to form a first bit group, a pair of first and second bit lines 20b and 20'b are connected to the memory cells 32' and 38' disposed in the second column thereof to form a second bit group and a pair of first and second bit lines 20c and 20'c are connected to the memory cells 34' and 40' disposed in the third column thereof to form a third bit group and so on.

All the memory cells are also identical to one another but each of the memory cell is modified to include a pair of first and second MOS field effect transistors Tr and Tr' respectively and a data storing capacitor C as shown in block 408 in Figure 2. More specifically, the first MOS field effect transistor Tr includes a gate electrode connected to the first address line 10a or 10b and one main electrode, in this case, a drain electrode connected to the second address line 10'a or 10'b and one main electrode or a drain electrode connected to the second bit line 20'a 20'B or 20'c. The two transistors Tr and TR' include source electrodes connected to the capacitor C subsequently connected to ground.

Further a pair of first and second peripheral control units 50 and 50' respectively are disposed so that the first unit 50 is connected to both the first address lines 10a and 10b respectively of the first and address groups and the first bit lines 20a, 20b and 20c respectively of the first, second of third bit groups, and the second unit 50' is connected to both the second address lines 10'a and 10'b or the address groups and the second bit lines 20'a, 20'b and 20'c of the bit groups. Then each of the peripheral control units 50 and 50' has connected thereto a set of first or second control lines 52 or 52' similar to those shown in Figure 1.

In operation, the first peripheral control unit 50 responds to a first address signal applied thereto through the first control lines 52 to select that first address and bit lines and therefore the mating memory cell as determined by the first address signal, for example, the memory cell 30' as in the arrangement of Figure 1. Simultaneously a second address signal is applied to the second peripheral control unit 50' through the second control lines 52' to select the second address and bit lines and therefore the associated memory cell as determined by the second address, for example, the memory cell 40'.

Thereafter data can be simultaneously written in the capacitors C, included in the two selected memory cells 30' and 40' in the same manner as described above in conjunction with Figure 1.

It is to be understood that, by applying simultaneously a first and a second address signal to the first and second peripheral control units 50 and 50', data can be simultaneously read out from those two memory cells as selected by the address signals respectively in the same manner as described above in conjunction with Figure 1.

While the present invention has been illustrated and discribed in conjunction with the simultaneous selection of two memory cells, it is to be understood that the present invention can be expanded to select simultaneously not less than three memory cells by increasing the number of address lines of each address groups, and that of the bit lines of each bit groups accordingly with increasing similarly the number of the peripheral control units and that of sets of control lines. This is attended with a corresponding increase in number of MOS field effect transistors included in each memory cell.

The present invention is advantageous in that a memory circuit embodying the same can be used in the following manners:

1) With the memory circuit employed as a dynamic memory unit, the refreshing operation can be separately performed with different memory cells resulting in the elemination of a waste time required for the refreshing cycle.

2) With the memory circuit employed as a buffer memory unit for the controller of disc type memory apparatus, an interface between the same and an associated digital computer can be operated at a very high speed.

3) The memory circuit may be effectively used with the so-called instruction leading system in which an instruction is first read out from an associated program and then the instruction is executed by an associated digital computer in order to increase the processing speed of the digital computers. This is because the instruction can be read out from the program stored in the memory circuit and executed by the digital computer while the next succeeding instruction is read out from the program.

4) The memory circuit is effectively used, as a common area with a plurality of digital computers.

5) The memory circuit is optimum for use as a cash memory unit for a digital computer. In this case it is possible to write an old program into the cash memory unit during the execution of a program effected by the digital computer.

6) With the memory circuit used as a buffer memory

- 11 -

unit for the character display, characters displayed on an associated cathode ray tube can be prevented from flickering. This is because display accesses can be effected separately from writing accesses.

While the present invention has been illustrated and described in conjunction with a single preferred embodiment thereof it is to be understood that numerous changes and modification may resorted to departing from the scope of the present invention. For example, it is to be understood that the present invention is not restricted to the MOS field effect transistors and that it is equally applicable to bipolar transistors. Also it will readily be understood that the present invention is equal applicable to a read only memory circuit other than a random access memory circuit such as described herein. In the read only memory circuit, the first address and bit lines or the second address and bit lines can be used only for reading purposes.

What is claimed is:

1. A memory control circuit comprising a plurality of address groups and a plurality of bit groups running in rows and columns to form a matrix, a memory control circuit comprising a plurality of address groups and a plurality of bit groups running in rows and columns to form a matrix, and a plurality of memory cells (30',32') disposed at the intersection of the matrix, characterised in that each of the address groups includes a plurality of address lines (10a, 10'a) disposed in parallel to one another, and that each of the bit groups includes a plurality of bit lines (20a, 20'a) disposed in parallel to one another, the number of address lines and the number of bit lines being equal, and that the memory cells (30', 32'....) arranged in each row are connected to said plurality of address lines included in a matching one of the address group, the memory cells arranged in each column being connected to said plurality of bit lines included in a matching one of the bit groups.

2. A memory control circuit comprising a plurality of address groups and a plurality of bit groups running in rows and columns to form a matrix, and a plurality of memory cells (30', 32') disposed at the intersection of the matrix characterised in that each of the address groups includes a first and second address lines (10a, 10'a) disposed in parallel to each other, and that each of said bit groups includes first and second bit lines disposed in parallel to each other, and that the memory cells (30', 32') arranged in each row are connected to said first and second address lines included in a matching one of the address groups, said memory cells arranged in each column being connected to said first and second bit lines included in a matching one of the bit groups.

3. A memory control circuit as claimed in claim 2 characterised in that each of said memory cells includes a first transistor (Tr) having one main electrode connected to an associated one of said first bit lines, the other main electrode, and a control electrode connected to an associated one of said first address lines, a second transistor (Tr') having one main electrode connected to an associated one of said second bit lines, the other main electrode, and a control electrode connected to an associated one of said second address lines, and a storing element (C) connected to ther other main electrodes of said first and second transistors (Tr, Tr').

4. A memory control circuit as claimed in claim 2 or 3 characterised in that a first peripheral control unit (50) is connected to all said first address lines and to all said first bit lines to select any one of said first address lines and any one of said first bit lines at a time; and that a second peripheral control unit (50') is connected to all said second address lines and to all said bit lines to select any one of said second address
lines and any one of said second bit lines at a time.

5. A memory control circuit as claimed in claim 3
or 4 characterised in that each of said first and second
transistors (Tr, Tr') comprises an MOS field effect transistor and said storing element (C) comprises a capacitor.

6. A memory control circuit as claimed in claim 4
characterised in that a first and a second set of control
lines (52,52') are connected to said first and second
peripheral control units respectively, and that said first
peripheral control unit (50) is responsive to a first
control signal applied thereto through said first set of
control lines (52) to select said first address and bit
lines as determined by said first control signal and said
second peripheral control unit (50') is responsive to a
second control signal applied thereto through said second
set of control lines (52') to select said second address
and bit lines as determined by said second control signal.

7. A memory control circuit as claimed in any one of
claims 2 to 6 characterised in that each of said memory
cells is constructed so that data are permitted to be
written in and read out from the same.

8. A memory control circuit as claimed in any one of
claims 2 to 6 characterised in that each of said memory
cells is constructed so that data are permitted only to be
read out therefrom.

9. A memory control circuit as claimed in claim 8 characterised in that one of said first and second address lines included in each of said address groups and an associated one of said first and second bit lines included in each of said bit groups are used only to read out data from the associated memory cells.

FIG.I. PRIOR ART

FIG.2.

2ND PERIPHERAL CONTROL UNIT

European Patent Office

**EUROPEAN SEARCH REPORT**

Application number
EP 80 30 2866

| Category | Citation of document with indication, where appropriate, of relevant passages | Relevant to claim |
|---|---|---|
| **DOCUMENTS CONSIDERED TO BE RELEVANT** | | |
| X | IBM TECHNICAL DISCLOSURE BULLETIN, vol. 18, no. 3, August 1975, pages 649-650 Armonk, U.S.A. L.M. ARZUBI: "Two-device storage cell" | 1-5 |
| | IEEE PROCEEDINGS OF THE TEXAS, Conference on Computing Systems, November 1975, IEEE Editor, pages 2B-1.1 - 2B-1.8 Long Beach, U.S.A. W.W. CHU et al.: "Multiaccess memory: An overview" <br> * Paragraph II: "Implementation"; figures 1-3 ' <br> & US - A - 4 104 719 (US NAVY) | 1,2,6 |
| | IBM TECHNICAL DISCLOSURE BULLETIN, vol. 14, no. 12, May 1972, pages 3737-3738 Armonk, U.S.A L.C. RADZIK: "Multiple image read-only storage" | 8,9 |
| | US - A - 3 643 236 (I.B.M.) | 1,4 |
| | US - A - 3 675 218 (I.B.M.) | 1 |
| A | US - A - 4 103 342 (I.B.M.) | 3,5 |
| A | US - A - 3 614 749 (BURROUGHS) | 3,5 |
| A | US - A - 3 931 617 (SIGNETICS) | 3 |
| A | FR - A - 2 402 277 (SIEMENS) | |
| P | & US - A - 4 168 538 (18-09-1979) | |
| A | US - A - 4 086 662 (HITACHI) ./. | 1 |

**CLASSIFICATION OF THE APPLICATION (Int. Cl.3)**

G 11 C 8/00
11/24

**TECHNICAL FIELDS SEARCHED (Int. Cl.3)**

G 11 C 8/00
11/24

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 26-11-1980 | SCHMIDT |

EPO Form 1503.1 06.78

European Patent Office

| Category | Citation of document with indication, where appropriate, of relevant passages | Relevant to claim |
|---|---|---|
| A | US - A - 4 125 877 (MOTOROLA) | 1 |
| A | US - A - 4 127 899 (I.B.M.) | 1 |

----

**DOCUMENTS CONSIDERED TO BE RELEVANT**

CLASSIFICATION OF THE APPLICATION (Int. Cl. 3)

TECHNICAL FIELDS SEARCHED (Int. Cl. 3)